# EUROPEAN PATENT APPLICATION

(11) **EP 1 328 020 A1**
(43) Date of publication of application: **16.07.2003**
(21) Application number: 02000605.2
(22) Date of filing: 10.01.2002
(51) Int. Cl.: H01L 23/367

(54) **Fin piece structure for heat dissipater**

(71) Applicant: Wei, Wen-Chen, Taipei Hsien (TW)
(72) Inventor: Wei, Wen-Chen, Taipei Hsien (TW)
(74) Representative: Zeitler, Giselher (DE)

(57) **Abstract**

The invention herein relates to a fin piece structure for a heat dissipater mainly constructed by cutting the heat dissipation piece into a plurality of bar shapes to be respectively bent upwards from the two sides to form a group of heat dissipation fins opposite each other; wherein the unbent bottom portion at the center is defined as a heat conducting plate and the heat dissipation fins are arranged in two outer and two inner rows with intervals; through the assembled heat dissipater, the surface area of heat dissipation can be substantially increased to smoothly conduct the air current and enhance the efficiency of heat dissipation.

## Description

### BACKGROUND OF THE INVENTION

### 1) FIELD OF THE INVENTION

A fin piece structure for a heat dissipater, more especially a group of heat dissipation fins opposite each other is formed by cutting and bending the heat dissipation pieces and is capable of substantially increasing the surface area of heat dissipation for fully enhancing the request of heat dissipation.

### 2) DESCRIPTION OF THE PRIOR ART

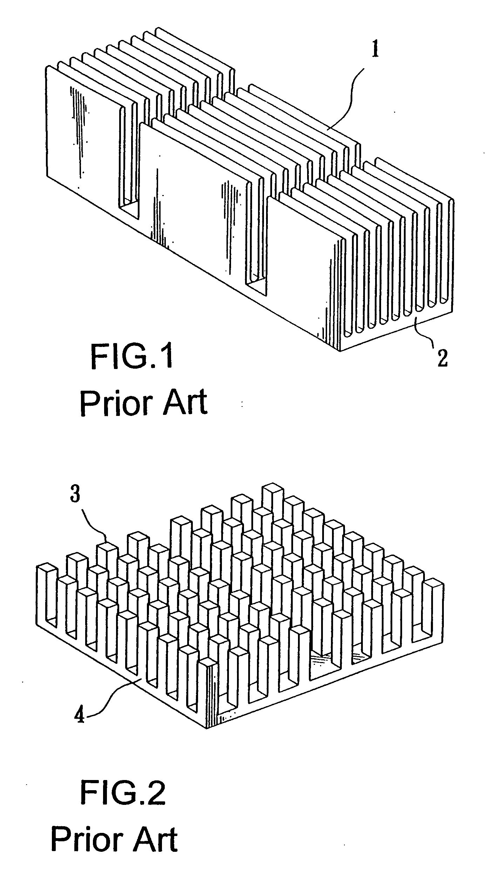

In order to solve the overheating problem of the components inside the computer central processing unit, the heat dissipation pieces are usually added to the components of the electronic heat sources, such as the CPU, the IC components, the power chips and the electric source supplier, to enable the high temperature generated by the electronic components to be conducted and diffused outwards by the heat dissipation pieces. However, the structure of most of the conventional heat dissipation pieces is molded in a single piece of extruded and processed aluminum with heat dissipation pieces (10) and the base plates, as shown in FIG. 1, and is subject to the limitations of compression molding and the extrusion technology in that the heat dissipation pieces (1) are usually wider and thicker, which not only results in a larger area of interfered air flow, but also a slower rate of heat conduction and, furthermore, since the number of the heat dissipation pieces is less, the area of heat dissipation is small, thus the efficiency of heat dissipation is limited. Therefore, the industrial field had developed another heat dissipation pieces, as indicated in FIG. 2, with several heat dissipation poles (4) mounted on the seat body (3) to conduct and diffuse the high temperature generated by the electronic components during execution outwards through the heat dissipation poles (4). Although this kind of heat dissipation pieces have larger heat dissipation area and space with better heat dissipation efficiency, the heat dissipation poles (4) have to be first manufactured as long blocks then rolled into heat dissipation poles (4) in equal lengths. The fabrication not only requires extra processing and is time-consuming, but also causes material consumption losses; furthermore, since the strip ribs are still thicker with more heat accumulation, the rate of heat dissipation is influenced; for the electronic heat generating components required for fast and longer execution, the heat dissipation efficiency is not ideal and fails in efficiently improving the shortcomings of the mentioned heat dissipation pieces.

In view of the shortcomings of the conventional heat dissipation pieces mentioned above, the inventor of the invention herein, researched diligently based on the professional experience for improvement and innovation, and culminated in the invention of the structure of the heat dissipation fins not only capable of fabricating more quantity of heat dissipation fins to have more heat dissipation fins in the same size of area and more air contact surfaces than what the conventional heat dissipation pieces have, to not only efficiently increase the heat dissipation area, but also save more material than what the conventional ones can do, to further lower the cost and obtain the greatest heat dissipation effect, to accelerate the heat dissipation efficiency of the heat source, to fulfill the function of the heat dissipation pieces and to specifically solve the overheating problems of the components in the computer.

### SUMMARY OF THE INVENTION

Therefore, the primary objective of the invention herein is to provide a structure of the heat dissipation fins through cutting and bending the heat dissipation pieces to form a group of a plurality of heat dissipation fins arranged oppositely for substantially increasing the surface area of heat dissipation, smoothly conducting the air flow and enhancing heat dissipation efficiency.

Another objective of the invention herein is to provide a structure of the heat dissipation fins through directly punch pressing the heat dissipation pieces into a plurality of heat dissipation fins without wasting any materials, but saving the materials, reducing the labor time and lowering the cost.

To enable a further understanding of the objectives, technology, methods and features of the specific structure of the invention herein, the brief description of the drawings below is followed by the detailed description of the preferred embodiment.

### BRIEF DESCRIPTION OF THE DRAWINGS

Figure 1 is a pictorial drawing of the conventional heat dissipation pieces.
Figure 2 is a pictorial drawing of another conventional heat dissipation pieces.
Figure 3 is a pictorial drawing of the outside view of the invention herein.
Figure 4 is a drawing of the top view of the invention herein.
Figure 5 is a development elevation of the plane of the invention herein.
Figure 6 is an pictorial and isometric drawing of the assembled invention herein.

### DETAILED DESCRIPTION OF THE PREFERRED EMBODIMENTS

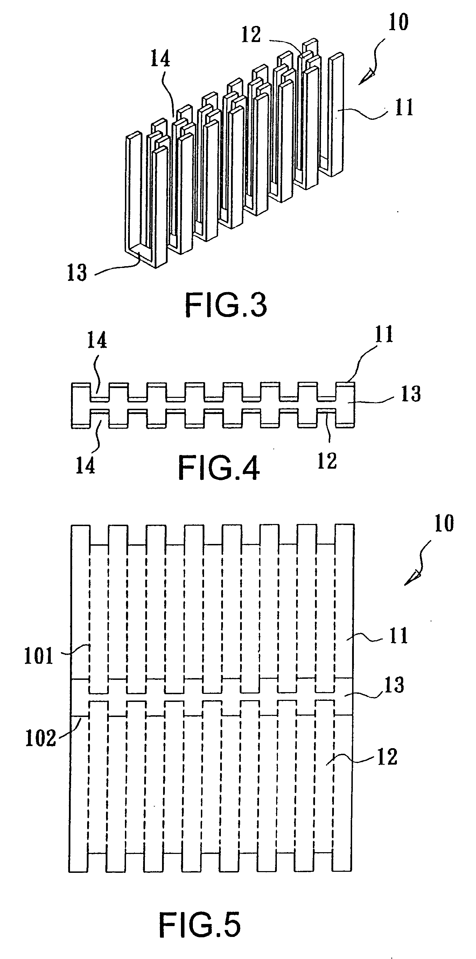

Referring to FIGs. 3 and 4 of the pictorial drawing of the outside view and the drawing of the top view of the invention herein, mainly a heat dissipation piece is cut into a plurality of strips in the forms of thin long pieces and bent respectively upwards from the two sides to define a group of U-shaped heat dissipation fins (10) arranged opposite each other in the number multiplying that of the conventional heat dissipation pieces; the unbent bottom portion at the center forms a heat conducting plate (13) with an alternation of wide and narrow widths, wherein, the group of heat dissipation fins (10) are bent upwards from the bottom portion at different positions to form unparallel outer and inner rows; the interval distance between two heat dissipation fins opposite each other in the outer row is wider defining the outer fins (11); the interval distance between two heat dissipation fins in the inner row is closer defining the inner fins (12); the outer fins (11) and the inner fins (12) are arranged alternatively to define all the two sides of the group of the heat dissipation fins (10) as the triangular section of interference current (14).

Referring to FIG. 5 of the development elevation of the plane of the invention herein, during punch pressing the invention herein, one needs only to cut along the predetermined cutting line (101) and bend along the press-bend line (102) upwards at the same time to form a group of heat dissipation fins (10), as shown in FIG. 3, without wasting any materials for manufacturing but to finish the invention herein by one punch pressing with no extra processing operation to save labor time, materials and lower the cost.

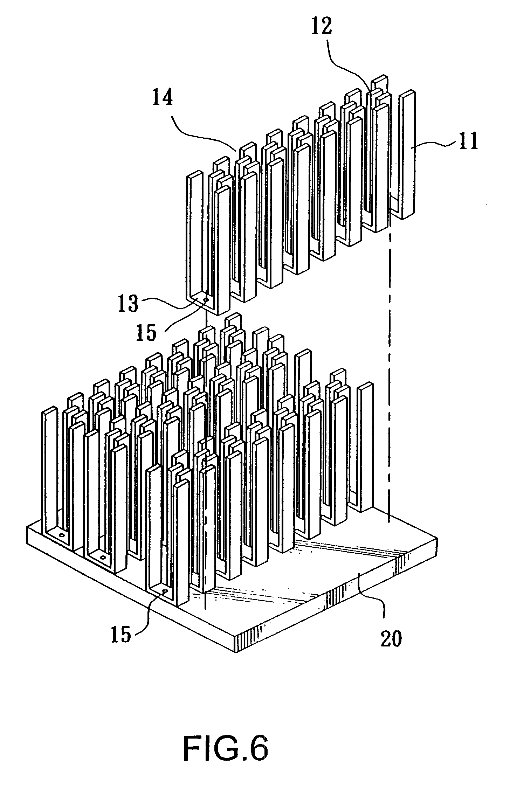

Referring to FIG. 6 of the pictorial and the isometric drawing of the assembled invention herein, during assembling, one needs only to stick the group of heat dissipation fins (10) onto the heat absorbing plate (20) by applying the heat conducting glue, or to pre-mount the riveted holes (15) on the heat conducting plates (13) for fastening by riveting. The assembling is relatively simple. The tall, thin and long pieces punch pressed from the fins of the group of the heat dissipation fins can, first, accelerate the rate of heat conduction, and secondly, since the multiplied number of the fins makes all the sides of the fins contact the air, increase the heat dissipation area substantially and augment the capacity of the entire hear diffusion; furthermore, the outer fins (11) and the inner fins (12) are designed to be arranged alternatively to define a triangular section of interference current (14) between the outer fins (11) and the inner fins (12) to allow the passing current to produce eddy current due to the differences of the angles and the air current volumes between the inner and the outer rows to enable each surface of the fins to evenly contact with the air current; furthermore, with the interval gaps formed among all the heat dissipation fins, the flowing rate of the air current can be relatively increased to enhance the entire heat dissipation efficiency so as to quickly diffuse the heat conducted from the heat absorbing plate (20) to the heat conducting plate (13).

However, the terminology utilized for the said drawings and components have been selected to facilitate the description of the invention herein and shall not be construed as a limitation on the patented scope of the invention herein; all substitutions of equivalent components based on the spirit of the invention herein shall still be regarded as within the protected scope and of the new patent rights granted to the invention herein.

In summation of the foregoing sections, the invention herein of a fin piece structure for a heat dissipater is an invention of reasonable perfection, not only significantly increasing the total heat dissipation area of the heat dissipation pieces, possessing excellent practicality, but also having an unprecedented structural spatial design that is original, innovational and capable of manifestly increasing the rate of heat dissipation and specifically enhancing the heat dissipation efficiency, is an invention of high characteristics surpassing the conventional technology and is progressive; therefore, the invention herein fully complies with all new patent application requirements and is hereby submitted to the patent bureau for review and the granting of the commensurate patent rights.

## Claims

1. A fin structure for a heat dissipater is mainly constructed by cutting the heat dissipation pieces into a plurality of bar shapes to be respectively bent upwards from the two sides to form a group of U-shaped heat dissipation fins opposite each other; the group of heat dissipation fins is bent upwards from the bottom portion at different positions to form unparallel outer and inner fins; the outer and the inner fins are mounted and arranged with intervals; the unbent bottom portion at the center defines the heat conducting plate.
